# FASCICULE DE BREVET EUROPEEN

(11) **EP 4 012 735 B1**
(45) Date de publication et mention de la délivrance du brevet: **09.07.2025**
(21) Numéro de dépôt: 21213288.0
(22) Date de dépôt: 09.12.2021
(51) Int. Cl.: H01G 4/33

(54) **PROCÉDÉ DE FABRICATION D'UN CONDENSATEUR**
VERFAHREN ZUR HERSTELLUNG EINES KONDENSATORS
METHOD FOR MANUFACTURING A CAPACITOR

(30) Priorité: 14.12.2020 FR 2013214
(43) Date de publication de la demande: 15.06.2022
(73) Titulaire: STMicroelectronics (Tours) SAS, 37100 Tours (FR)
(72) Inventeur: BOUFNICHEL, Mohamed, 37380 MONNAIE (FR)
(74) Mandataire: Cabinet Beaumont

(56) Documents cités:
- EP-A2- 1 258 912
- KR-A- 20030 056 917
- US-A1- 2006 137 710
- US-A1- 2013 284 701

## Description

### Domaine technique

La présente description concerne de façon générale la fabrication d'un circuit intégré, et vise plus particulièrement la fabrication d'un circuit intégré comprenant un condensateur, par exemple un circuit intégré passif.

### Technique antérieure

Divers procédés de fabrication de circuits intégrés comportant des condensateurs ont été proposés. Ces procédés présentent divers inconvénients. Il serait souhaitable de pouvoir disposer d'un procédé de fabrication d'un circuit intégré comprenant un condensateur, ce procédé palliant tout ou partie des inconvénients des procédés connus.

Le document KR20030056917A décrit un exemple de procédé connu de fabrication d'un condensateur comprenant deux étapes de gravure chimique.

### Résumé de l'invention

Un mode de réalisation prévoit un procédé de fabrication d'un condensateur, comprenant les étapes successives suivantes :
a. former un empilement comportant, dans l'ordre à partir de la face supérieure d'un substrat, une première couche conductrice en aluminium ou un alliage à base d'aluminium, une première électrode, une première couche diélectrique et une deuxième électrode ;
b. graver, par gravure plasma chimique, une partie supérieure de l'empilement, ladite gravure plasma chimique étant interrompue avant la face supérieure de la première couche conductrice ; et
c. graver, par gravure plasma physique, une partie inférieure de l'empilement, ladite gravure plasma physique étant interrompue sur la face supérieure de la première couche conductrice.

Selon un mode de réalisation, ladite gravure plasma chimique, à l'étape b), comprend une première étape de gravure plasma chimique au moyen d'un plasma à base de chlore, suivie d'une deuxième étape de gravure plasma chimique au moyen d'un plasma à base de fluor.

Selon un mode de réalisation, la deuxième étape de gravure plasma chimique et l'étape de gravure plasma physique sont mises en oeuvre dans une même chambre de gravure, une étape de purge de ladite chambre de gravure étant mise en oeuvre entre les deux étapes.

Selon un mode de réalisation, ladite gravure plasma chimique, à l'étape b), comprend une unique étape de gravure plasma chimique au moyen d'un plasma à base de chlore.

Selon un mode de réalisation, ladite gravure plasma chimique, à l'étape b), comprend une unique étape de gravure plasma chimique au moyen d'un plasma à base de fluor.

Selon un mode de réalisation, l'empilement comprend en outre une deuxième couche conductrice revêtant la deuxième électrode.

Selon un mode de réalisation, la gravure plasma physique, à l'étape c), est réalisée au moyen d'un plasma d'argon.

Selon un mode de réalisation, la deuxième couche conductrice est en aluminium ou en un alliage comprenant de l'aluminium.

Selon un mode de réalisation, la première électrode est en nitrure de tantale.

Selon un mode de réalisation, ladite partie inférieure de l'empilement comprend au moins une partie de l'épaisseur de la première électrode.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe schématique d'un exemple d'un condensateur selon un mode de réalisation ;
la figure 2 est une vue en coupe illustrant une étape d'un procédé de fabrication du condensateur de la figure 1 ;
la figure 3 est une vue en coupe illustrant une autre étape d'un procédé de fabrication du condensateur de la figure 1 ;
la figure 4 est une vue en coupe illustrant une autre étape d'un procédé de fabrication du condensateur de la figure 1 ;
la figure 5 est une vue en coupe illustrant une autre étape d'un procédé de fabrication du condensateur de la figure 1 ;
la figure 6 est une vue en coupe illustrant une étape d'un procédé de fabrication du condensateur de la figure 1 selon un premier mode de réalisation ;
la figure 7 est une vue en coupe illustrant une autre étape d'un procédé de fabrication du condensateur de la figure 1 selon le premier mode de réalisation ;
la figure 8 est une vue en coupe illustrant une autre étape d'un procédé de fabrication du condensateur de la figure 1 selon le premier mode de réalisation ;
la figure 9 est une vue en coupe illustrant une autre étape d'un procédé de fabrication du condensateur de la figure 1 selon le premier mode de réalisation ;
la figure 10 est une vue en coupe illustrant une étape d'un procédé de fabrication du condensateur de la figure 1 selon un deuxième mode de réalisation ; et
la figure 11 est une vue en coupe illustrant une autre étape d'un procédé de fabrication du condensateur de la figure 1 selon le deuxième mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, on s'intéresse ici principalement à une étape de gravure permettant de découvrir une couche métallique en vue de reprendre un contact électrique sur une électrode inférieure d'un condensateur d'un circuit intégré. Les autres étapes du procédé de fabrication du circuit condensateur et du circuit intégré sont à la portée de la personne du métier et ne seront pas décrites en détail.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

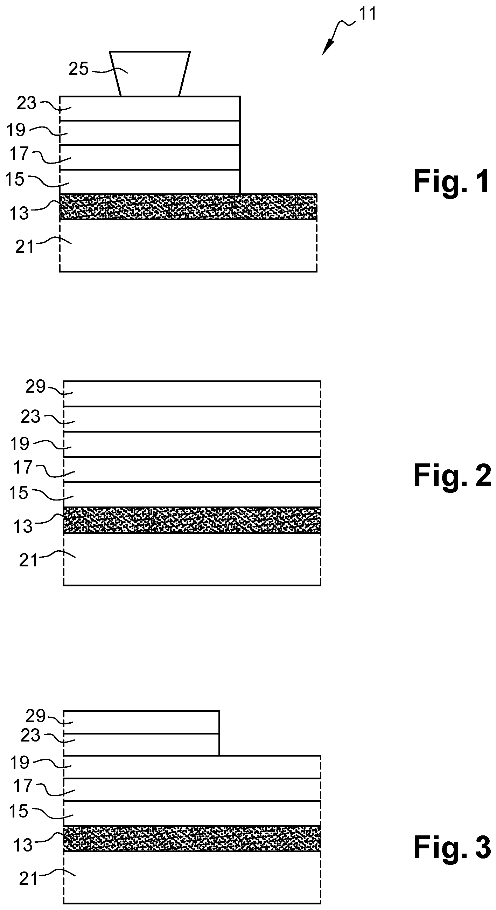

La figure 1 est une vue en coupe d'un exemple d'un condensateur 11 selon un mode de réalisation.

Le condensateur 11 comprend, dans l'ordre à partir de la face supérieure d'un substrat ou support 21 :
une couche électriquement conductrice 13, aussi appelée couche de redistribution (RDL, redistribution layer) ;
une première électrode 15 aussi appelée électrode inférieure ;
une couche 17 en un matériau diélectrique ; et une deuxième électrode 19 aussi appelée électrode supérieure.

Dans l'exemple représenté, la couche de redistribution 13 est en contact, par sa face inférieure, avec la face supérieure du substrat 21, l'électrode inférieure 15 est en contact, par sa face inférieure, avec la face supérieure de la couche 13, la couche diélectrique 17 est en contact, par sa face inférieure, avec la face supérieure de l'électrode inférieure 15, et l'électrode supérieure 19 est en contact, par sa face inférieure, avec la face supérieure de la couche diélectrique 17.

Selon un aspect des modes de réalisation décrits, la couche conductrice 13 est en aluminium ou en un alliage comprenant de l'aluminium, par exemple un alliage d'aluminium et de cuivre (AlCu) ou un alliage d'aluminium, de cuivre et de silicium (AlSiCu). A titre d'exemple, la couche 13 a une épaisseur comprise entre 0,5 µm et 3 µm, de préférence égale à environ 1,5 µm.

Les électrodes 15 et 19 peuvent être en un même matériau ou en des matériaux différents. Les électrodes 15 et 19 sont par exemple en nitrure de tantale. A titre de variante, les électrodes 15 et/ou 19 peuvent être en silicium polycristallin ou en platine. A titre d'exemple, l'électrode 15 a une épaisseur comprise entre 20 nm et 200 nm, de préférence de l'ordre d'environ 80 nm. A titre d'exemple, l'électrode 19 a une épaisseur comprise entre 20 nm et 200 nm, de préférence de l'ordre d'environ 80 nm.

La couche diélectrique 17 est par exemple en nitrure de silicium (Si₃N₄) ou en oxynitrure de tantale (TaON). A titre d'exemple, la couche diélectrique 17 a une épaisseur comprise entre 20 nm et 600 nm, de préférence égale à environ 110 nm ou à environ 440 nm.

Dans l'exemple de la figure 1, le condensateur 11 comprend en outre :
une couche conductrice 23, sur et en contact avec la face supérieure de l'électrode 19 ; et
un plot métallique 25 sur et en contact avec la face supérieure de la couche conductrice 23.

A titre de variante, la couche conductrice supérieure 23 peut être omise, le plot métallique 25 étant alors disposé sur et en contact avec la face supérieure de l'électrode supérieure 19 du condensateur.

Le support 21 est, par exemple, en verre ou en un silicium, de préférence fortement résistif. Le support 21 et la couche 13 sont, par exemple, séparés l'un de l'autre par une couche diélectrique, non représentée, par exemple une couche d'oxyde, par exemple du verre de silicium non dopé (USG, Undoped Silicon Glass) ou tout autre oxyde de silicium.

La couche conductrice 23 est par exemple en aluminium, et a, par exemple, une épaisseur comprise entre 200 nm et 1 µm, de préférence, égale à environ 400 nm. La couche 23 permet notamment d'augmenter la conductivité électrique latérale de l'électrode supérieure 19 qu'elle recouvre.

Le plot métallique 25 est par exemple, en cuivre.

Dans l'exemple représenté, les électrodes 15 et 19 et les couches 23 et 17 sont en retrait par rapport à la couche conductrice 13. Autrement dit, une portion de la couche conductrice 13 n'est pas recouverte par les électrodes 15 et 19 et les couches 23 et 17. Ceci permet, lors d'une étape de fabrication non détaillée, la reprise d'un contact électrique, par l'intermédiaire de la couche conductrice 13, sur l'électrode inférieure 15 du condensateur, par exemple, au moyen d'un fil métallique soudé à la face supérieure de la portion exposée de la couche 13.

Les figures 2, 3, 4 et 5 sont des vues en coupe illustrant des étapes successives d'un exemple d'un procédé de fabrication du condensateur 11 de la figure 1.

La figure 2 représente un empilement de départ comprenant, successivement, le support 21, la couche conductrice inférieure 13, l'électrode inférieure 15, la couche diélectrique 17, l'électrode supérieure 19, la couche conductrice supérieure 23, et une couche de protection 29, par exemple en résine, recouvrant la face supérieure de la couche conductrice supérieure 23.

A ce stade, les couches de l'empilement sont alignées. En particulier, les électrodes 15 et 19 et les couches 17, 23 et 29 s'étendent chacune au-dessus de toute la surface supérieure de la couche conductrice inférieure 13.

La figure 3 illustre la structure obtenue à l'issue d'une étape de retrait localisé de la couche de protection 29 et de la couche conductrice supérieure 23 en vis-à-vis de la portion de la couche conductrice inférieure 13 que l'on souhaite exposer.

Le retrait localisé de la couche de protection 29 peut être effectué par photolithographie.

La couche 23 peut ensuite être gravée par une première gravure plasma chimique, par exemple au moyen d'un plasma à base de chlore, en vis-à-vis de l'ouverture formée dans la couche 29, en utilisant la couche 29 comme masque de gravure. Dans cet exemple, la couche 23 est gravée sur toute son épaisseur lors de cette première gravure chimique.

Dans l'exemple représenté, la première gravure chimique est interrompue sur la face supérieure de l'électrode 19.

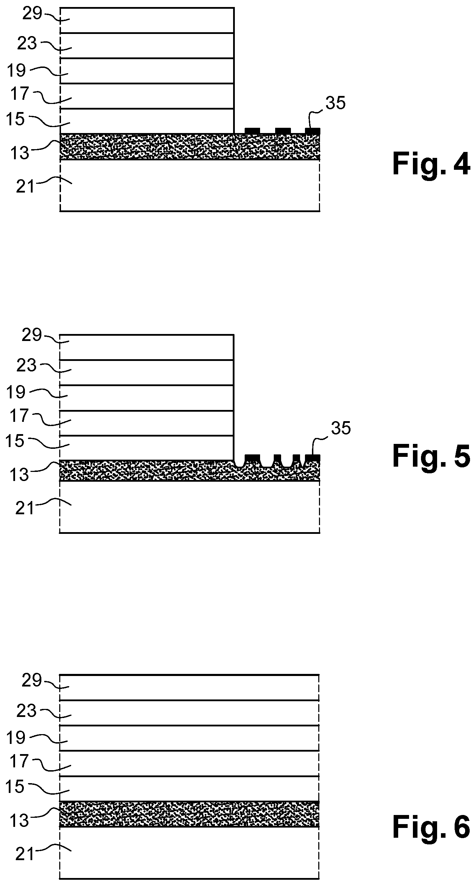

La figure 4 illustre la structure obtenue à l'issue d'une étape de retrait localisé des couches 19, 17 et 15 en vis-à-vis de la portion de la couche conductrice inférieure 13 que l'on souhaite exposer.

Les couches 19, 17 et 15 peuvent être gravée par une deuxième gravure plasma chimique, par exemple au moyen d'un plasma à base de fluor, en vis-à-vis de l'ouverture formée dans les couches 29 et 23, en utilisant la couche 29 comme masque de gravure. Dans cet exemple, les couches 19, 17 et 15 sont gravées sur toute leur épaisseur lors de cette deuxième gravure chimique.

Dans l'exemple représenté, la deuxième gravure chimique est interrompue sur la face supérieure de la couche conductrice 13.

La deuxième étape de gravure chimique, au fluor, présente en effet l'avantage de graver les couches 19, 17 et 15 de façon sélective par rapport à la couche 13, contenant de l'aluminium.

Un inconvénient de ce procédé est que, lors de la deuxième étape de gravure plasma chimique, le plasma à base de fluor vient en contact avec la face supérieure de la couche conductrice 13, contenant de l'aluminium. Des atomes de fluor viennent alors se lier à des atomes d'aluminium à la surface de la couche 13, créant une couche monoatomique 35 de fluorure d'aluminium (AlF) à la surface de la couche 13. Comme l'illustre schématiquement la figure 4, la couche 35 est irrégulière et ne recouvre pas de façon continue la portion exposée de la couche conductrice 13.

La figure 5 illustre la structure obtenue à l'issue d'une étape ultérieure de gravure chimique humide, par exemple au moyen d'un ou plusieurs acides, par exemple au moyen d'une solution connue sous la dénomination commerciale "Pvapox", comprenant un mélange d'acide fluorhydrique (HF), de fluorure d'ammonium (NH₄F), d'acide acétique (CH₃COOH) et de benzotriazole (C₆H₅N₃).

Cette gravure chimique humide peut par exemple être utilisée pour retirer localement, en vis-à-vis de la face supérieure de la couche conductrice 13, une couche de passivation (non visible sur les figures) préalablement déposée sur la face supérieure de la structure de la figure 4.

La gravure chimique humide est par exemple précédée d'une étape (non détaillée sur les figures) de dépôt d'une couche d'un oxyde, par exemple une couche en USG sur l'ensemble de la structure. L'étape de gravure chimique humide permet notamment de retirer une partie de la couche d'oxyde située sur et en contact avec la face supérieure de la portion de la couche 13 exposée à l'étape de gravure plasma de la figure 4.

La solution de gravure utilisée à l'étape de la figure 5 tend à consommer superficiellement la partie exposée de la couche conductrice 13. Toutefois, cette gravure superficielle est bloquée par les résidus 35 de fluorure d'aluminium, qui, eux, sont résistants à la solution utilisée et plus généralement aux attaques acides.

Il se produit ainsi un phénomène de micro-masquage conduisant à la formation de rugosités sur la face supérieure de la couche conductrice 13.

Ces rugosités dégradent la qualité du contact électrique repris ultérieurement sur la face supérieure de la couche 13. En particulier, ces rugosités ne permettent pas une bonne connexion électrique entre un fil et la couche 13 au moyen d'une soudure.

Les figures 6, 7, 8 et 9 sont des vues en coupe illustrant des étapes successives d'un exemple d'un procédé de fabrication du condensateur 11 de la figure 1 selon un premier mode de réalisation.

La figure 6 illustre un empilement de départ identique à l'empilement illustré en figure 2.

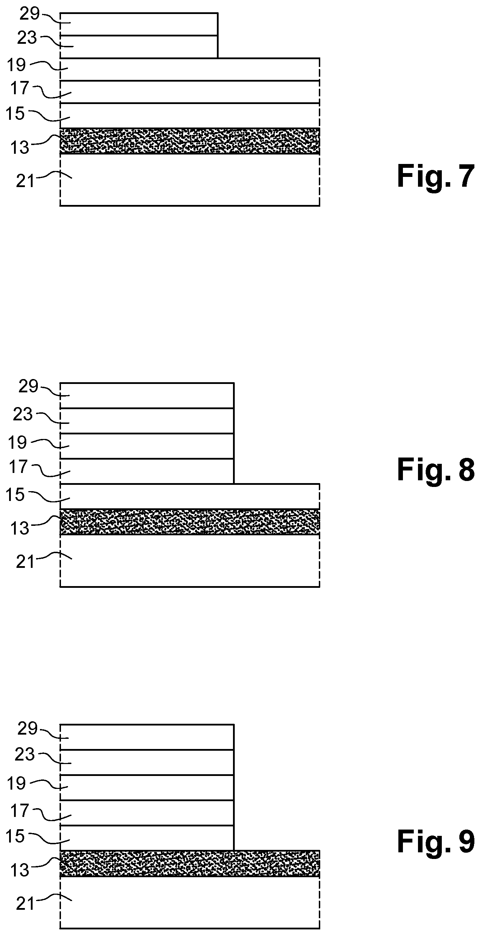

La figure 7 illustre la structure obtenue à l'issue d'une étape de retrait localisé de la couche de protection 29 et de la couche conductrice supérieure 23 en vis-à-vis de la portion de la couche conductrice inférieure 13 que l'on souhaite exposer.

Ces étapes sont par exemple identiques ou similaires aux étapes décrites ci-dessus en relation avec la figure 3.

En particulier, le retrait localisé de la couche de protection 29 peut être effectué par photolithographie. La couche 23 peut ensuite être gravée par une première gravure plasma chimique, par exemple au moyen d'un plasma à base de chlore, en vis-à-vis de l'ouverture formée dans la couche 29.

Dans l'exemple représenté, la première gravure chimique est interrompue sur la face supérieure de l'électrode 19.

La figure 8 illustre la structure obtenue à l'issue d'une étape de retrait localisé des couches 19 et 17 en vis-à-vis de la portion de la couche conductrice inférieure 13 que l'on souhaite exposer.

Les couches 19 et 17 peuvent être gravée par une deuxième gravure plasma chimique, par exemple au moyen d'un plasma à base de fluor, de façon similaire à ce qui a été décrit ci-dessus en relation avec la figure 4.

Dans cet exemple, les couches 19 et 17 sont gravées sur toute leur épaisseur lors de cette deuxième gravure chimique.

A la différence de ce qui a été décrit précédemment en relation avec la figure 4, dans cet exemple, la deuxième gravure plasma chimique est interrompue avant d'atteindre la face supérieure de la couche conductrice inférieure 13.

Dans l'exemple représenté, la deuxième gravure plasma chimique est interrompue sur la face supérieure de l'électrode inférieure 15.

La deuxième gravure plasma chimique est par exemple similaire à ce qui a été décrit ci-dessus en relation avec la figure 4. A titre d'exemple, la deuxième gravure plasma chimique est réalisée au moyen d'un plasma à base de fluor.

La deuxième étape de gravure plasma chimique étant arrêtée avant de déboucher sur la couche 13, le plasma à base de fluor n'entre pas en contact avec la couche 13, ce qui permet d'éviter la formation de la couche de fluor d'aluminium 35 (figure 4).

La figure 9 illustre la structure obtenue à l'issue d'une étape de retrait localisé de la couche d'électrode inférieure 15 en vis-à-vis de la portion de la couche conductrice inférieure 13 que l'on souhaite exposer.

Dans cet exemple, la couche 15 est retirée par gravure plasma physique, au moyen d'un plasma d'un gaz ne présentant pas d'affinité avec l'aluminium, par exemple, un plasma d'un gaz neutre, par exemple un plasma d'argon ou d'azote, de préférence un plasma d'argon. Dans cet exemple, la gravure physique est induite par des ions du gaz neutre, par exemple des ions d'argon, accélérés par une tension de polarisation.

La vitesse de gravure physique de l'électrode 15 est, par exemple, égale à environ 50 nm/min alors qu'elle est dix fois plus importante lors d'une gravure plasma chimique au fluor et quinze fois plus importante lors d'une gravure plasma chimique au chlore.

Dans cet exemple, la gravure plasma physique est interrompue lorsque la face supérieure de la couche conductrice 13 est dévoilée, c'est-à-dire lorsque l'électrode 15 a été gravée sur toute son épaisseur.

Un avantage du procédé décrit en relation avec les figures 6 à 9 est que l'on vient déboucher sur la couche conductrice 13 à l'aide d'une gravure plasma physique neutre. Ceci permet d'éviter la formation de fluorure d'aluminium sur la face exposée de la couche conductrice 13. Ainsi, la formation de rugosités sur la face supérieure de la couche conductrice 13, telle que décrite en relation avec la figure 5, peut être évitée. Ceci permet de réaliser une connexion électrique plus fiable et plus performante sur la face supérieure de la couche 13.

A titre de variante, non représentée, la première gravure plasma chimique (figure 7) peut être poursuivie à travers tout ou partie de l'épaisseur de l'électrode supérieure 19 et être interrompue dans l'électrode 19 ou sur la face supérieure de la couche diélectrique 17.

Dans une autre variante non représentée, la première gravure plasma chimique peut être poursuivie à travers tout ou partie de l'épaisseur de la couche diélectrique 17 et être interrompue dans la couche diélectrique 17 ou sur la face supérieure de l'électrode 15.

Dans une autre variante, non représentée, la deuxième étape de gravure plasma chimique (figure 8) est interrompue avant d'atteindre la face supérieure de l'électrode 15, par exemple sur la face supérieure de la couche diélectrique 17 ou dans la couche diélectrique 17.

Dans une autre variante, non représentée, une partie de l'épaisseur de l'électrode 15 est retirée lors de la deuxième étape de gravure plasma chimique. Autrement dit, la deuxième étape de gravure plasma chimique est interrompue dans la couche d'électrode inférieure 15.

A titre d'exemple, la première étape de gravure plasma chimique est mise en oeuvre dans un premier outil de gravure et la deuxième étape de gravure plasma chimique et l'étape de gravure plasma physique sont mises en oeuvre dans un deuxième outil de gravure différent du premier outil.

Dans ce cas, une purge de la chambre de gravure du deuxième outil peut être réalisée entre la deuxième étape de gravure plasma chimique et l'étape de gravure plasma physique, de façon à éviter que des atomes de fluor ne subsistent dans la chambre de gravure lors de l'étape de gravure plasma physique. La purge a par exemple une durée comprise entre 10 secondes et 20 secondes.

On notera que dans le cas où la couche conductrice supérieure 23 à base d'aluminium est omise, la première étape de gravure plasma chimique, au moyen d'un plasma à base de chlore, peut être omise. Autrement dit, seules deux étapes de gravure peuvent être prévues, à savoir la deuxième étape de gravure plasma chimique (figure 8), au moyen d'un plasma à base de fluor, et l'étape de gravure plasma physique (figure 9), au moyen d'un plasma d'un gaz neutre, par exemple un plasma d'argon.

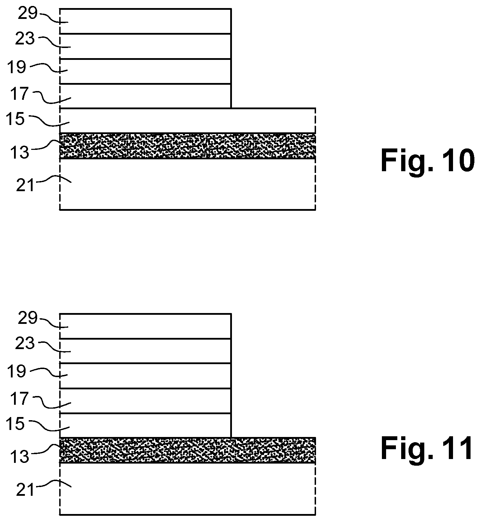

Les figures 10 et 11 sont des vues en coupe illustrant des étapes successives d'un exemple d'un procédé de fabrication du condensateur 11 de la figure 1 selon un deuxième mode de réalisation.

Dans ce deuxième mode de réalisation, la deuxième étape de gravure plasma chimique, au moyen d'un plasma à base de fluor, est omise. Autrement dit, seules deux étapes de gravure sont prévues, à savoir la première étape de gravure plasma chimique, au moyen d'un plasma à base de chlore, et l'étape de gravure plasma physique, au moyen d'un plasma d'un gaz neutre, par exemple un plasma d'argon.

A titre d'exemple, on part d'un empilement initial similaire à celui de la figure 6.

La figure 10 illustre la structure obtenue à l'issue d'une étape de retrait localisé de la couche de protection 29 et des couches 23, 19 et 17 en vis-à-vis de la portion de la couche conductrice inférieure 13 que l'on souhaite exposer.

Le retrait localisé de la couche de protection 29 peut être effectué par photolithographie.

Les couches 23, 19 et 17 peuvent ensuite être gravées par une première gravure plasma chimique, par exemple au moyen d'un plasma à base de chlore, en vis-à-vis de l'ouverture formée dans la couche 29, en utilisant la couche 29 comme masque de gravure.

La première gravure plasma chimique est interrompue avant d'atteindre la face supérieure de la couche conductrice inférieure 13.

Dans l'exemple représenté, la première gravure plasma chimique est interrompue sur la face supérieure de l'électrode inférieure 15.

La figure 11 illustre la structure obtenue à l'issue d'une étape de retrait localisé de la couche d'électrode inférieure 15 en vis-à-vis de la portion de la couche conductrice inférieure 13 que l'on souhaite exposer.

Dans cet exemple, la couche 15 est retirée par gravure plasma physique, de façon similaire à ce qui a été décrit ci-dessus en relation avec la figure 9.

A titre de variante, non représentée, la première gravure plasma chimique (figure 10) peut être interrompue avant d'atteindre la face supérieure de l'électrode 15, par exemple sur la face supérieure de la couche diélectrique 17 ou dans la couche diélectrique 17.

Dans une autre variante, non représentée, une partie de l'épaisseur de l'électrode 15 est retirée lors de la première étape de gravure plasma chimique.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation ne se limitent pas aux exemples de valeurs numériques ni aux exemples de matériaux mentionnés dans la présente description.

Enfin, la mise en oeuvre pratique des modes de réalisation et variantes décrits est à la portée de la personne du métier à partir des indications fonctionnelles données ci-dessus.

## Revendications

1. Procédé de fabrication d'un condensateur, comprenant les étapes successives suivantes :
a) former un empilement comportant, dans l'ordre à partir de la face supérieure d'un substrat (21), une première couche conductrice (13) en aluminium ou un alliage à base d'aluminium, une première électrode (15), une première couche diélectrique (17) et une deuxième électrode (19) ;
b) graver, par gravure plasma chimique, une partie supérieure de l'empilement, ladite gravure plasma chimique étant interrompue avant la face supérieure de la première couche conductrice (13) ; et
c) graver, par gravure plasma physique, une partie inférieure de l'empilement, ladite gravure plasma physique étant interrompue sur la face supérieure de la première couche conductrice (13).

2. Procédé selon la revendication 1, dans lequel, à l'étape b), ladite gravure plasma chimique comprend une première étape de gravure plasma chimique au moyen d'un plasma à base de chlore, suivie d'une deuxième étape de gravure plasma chimique au moyen d'un plasma à base de fluor.

3. Procédé selon la revendication 2, dans lequel la deuxième étape de gravure plasma chimique et l'étape de gravure plasma physique sont mises en oeuvre dans une même chambre de gravure, une étape de purge de ladite chambre de gravure étant mise en oeuvre entre les deux étapes.

4. Procédé selon la revendication 1, dans lequel, à l'étape b), ladite gravure plasma chimique comprend une unique étape de gravure plasma chimique au moyen d'un plasma à base de chlore.

5. Procédé selon la revendication 1, dans lequel, à l'étape b), ladite gravure plasma chimique comprend une unique étape de gravure plasma chimique au moyen d'un plasma à base de fluor.

6. Procédé selon l'une quelconque des revendications 1 à 5, dans lequel l'empilement comprend en outre une deuxième couche conductrice (23) revêtant la deuxième électrode (19).

7. Procédé selon l'une quelconque des revendications 1 à 6, dans lequel, à l'étape c), la gravure plasma physique est réalisée au moyen d'un plasma d'argon.

8. Procédé selon l'une quelconque des revendications 1 à 7, dans lequel la deuxième couche conductrice (23) est en aluminium ou en un alliage comprenant de l'aluminium.

9. Procédé selon l'une quelconque des revendications 1 à 8, dans lequel la première électrode (15) est en nitrure de tantale.

10. Procédé selon l'une quelconque des revendications 1 à 9, dans lequel ladite partie inférieure de l'empilement comprend au moins une partie de l'épaisseur de la première électrode (15).

## Patentansprüche

1. Verfahren zur Herstellung eines Kondensators, das die folgenden aufeinanderfolgenden Schritte aufweist:
a) Ausbilden eines Stapels aufweisend, in der Reihenfolge von der Oberseite eines Substrats (21) aus, eine erste leitfähige Schicht (13) aus Aluminium oder einer Aluminiumlegierung, eine erste Elektrode (15), eine erste dielektrische Schicht (17) und eine zweite Elektrode (19);
b) Ätzen, durch chemisches Plasmaätzen, eines oberen Abschnitts des Stapels, wobei das chemische Plasmaätzen vor der Oberseite der ersten leitfähigen Schicht (13) unterbrochen wird; und
c) Ätzen, durch physikalisches Plasmaätzen, eines unteren Abschnitts des Stapels wobei das physikalische Plasmaätzen auf der Oberseite der ersten leitfähigen Schicht (13) unterbrochen wird.

2. Verfahren nach Anspruch 1, wobei in Schritt b) das chemische Plasmaätzen einen ersten Schritt des chemischen Plasmaätzens mittels eines chlorbasierten Plasmas, gefolgt von einem zweiten Schritt des chemischen Plasmaätzens mittels eines fluorbasierten Plasmas, aufweist.

3. Verfahren nach Anspruch 2, wobei der zweite chemische Plasmaätzschritt und der physikalische Plasmaätzschritt in derselben Ätzkammer durchgeführt werden, wobei zwischen den beiden Schritten ein Spülschritt der Ätzkammer durchgeführt wird.

4. Verfahren nach Anspruch 1, wobei in Schritt b) das chemische Plasmaätzen einen einzigen Schritt des chemischen Plasmaätzens mittels eines chlorbasierten Plasmas aufweist.

5. Verfahren nach Anspruch 1, wobei in Schritt b) das chemische Plasmaätzen einen einzigen Schritt des chemischen Plasmaätzens mittels eines Fluor-basierten Plasmas aufweist.

6. Verfahren nach einem der Ansprüche 1 bis 5, wobei der Stapel ferner eine zweite leitfähige Schicht (23) aufweist, die die zweite Elektrode (19) bedeckt.

7. Verfahren nach einem der Ansprüche 1 bis 6, wobei in Schritt c) das physikalische Plasmaätzen mittels eines Argonplasmas durchgeführt wird.

8. Verfahren nach einem der Ansprüche 1 bis 7, wobei die zweite leitfähige Schicht (23) aus Aluminium oder einer Aluminium enthaltenden Legierung besteht.

9. Verfahren nach einem der Ansprüche 1 bis 8, wobei die erste Elektrode (15) aus Tantalnitrid besteht.

10. Verfahren nach einem der Ansprüche 1 bis 9, wobei der untere Abschnitt des Stapels mindestens einen Teil der Dicke der ersten Elektrode (15) aufweist.

## Claims

1. Method of manufacturing a capacitor, comprising the successive steps of:
a) forming a stack comprising, in the order from the upper surface of a substrate (21), a first conductive layer (13) made of aluminum or an aluminum-based alloy, a first electrode (15), a first dielectric layer (17), and a second electrode (19);
b) etching, by chemical plasma etching, an upper portion of the stack, said chemical plasma etching being interrupted before the upper surface of the first conductive layer (13); and
c) etching, by physical plasma etching, a lower portion of the stack, said physical plasma etching being interrupted on the upper surface of the first conductive layer (13).

2. Method according to claim 1, wherein, at step b), said chemical plasma etching comprises a first step of chemical plasma etching by means of a chlorine-based plasma, followed by a second step of chemical plasma etching by means of a fluorine-based plasma.

3. Method according to claim 2, wherein the second chemical plasma etching step and the physical plasma etching step are implemented in a same etch chamber, a step of purging of said etching chamber being implemented between the two steps.

4. Method according to claim 1, wherein, at step b), said chemical plasma etching comprises a single step of chemical plasma etching by means of a chlorine-based plasma.

5. Method according to claim 1, wherein, at step b), said chemical plasma etching comprises a single step of chemical plasma etching by means of a fluorine-based plasma.

6. Method according to any of claims 1 to 5, wherein the stack further comprises a second conductive layer (23) coating the second electrode (19).

7. Method according to any of claims 1 to 6, wherein, at step c), the physical plasma etching is performed by means of an argon plasma.

8. Method according to any of claims 1 to 7, wherein the second conductive layer (23) is made of aluminum or of an alloy comprising aluminum.

9. Method according to any of claims 1 to 8, wherein the first electrode (15) is made of tantalum nitride.

10. Method according to any of claims 1 to 9, wherein said lower portion of the stack comprises at least a portion of the thickness of the first electrode (15).
